# EUROPÄISCHE PATENTSCHRIFT

(11) **EP 3 523 637 B1**
(45) Veröffentlichungstag und Bekanntmachung des Hinweises auf die Patenterteilung: **16.02.2022**
(21) Anmeldenummer: 17780354.1
(22) Anmeldetag: 27.09.2017
(51) Int. Cl.: G01N 27/12

(54) **WÄRMEISOLIERTES MIKROSYSTEM**
HEAT-INSULATING MICROSYSTEM
MICROSYSTEME THERMIQUEMENT ISOLANT

(30) Priorität: 07.10.2016 DE 102016119031
(43) Veröffentlichungstag der Anmeldung: 14.08.2019
(73) Patentinhaber: Fraunhofer-Gesellschaft zur Förderung der angewandten Forschung e.V., 80686 München (DE)
(72) Erfinder: LISEC, Thomas, 25524 Itzehoe (DE); QUENZER, Hans-Joachim, 25524 Itzehoe (DE)
(74) Vertreter: Strehl Schübel-Hopf & Partner
(86) Internationale Anmeldenummer: PCT/EP2017/074467
(87) Internationale Veröffentlichungsnummer: WO 2018/065272

(56) Entgegenhaltungen:
- DE-A1-102011 010 899
- US-A1- 2009 158 859
- US-A1- 2013 075 930
- LUCKLUM F ET AL: "High temperature micro-hotplates on porous silicon substrates", 2013 TRANSDUCERS & EUROSENSORS XXVII: THE 17TH INTERNATIONAL CONFERENCE ON SOLID-STATE SENSORS, ACTUATORS AND MICROSYSTEMS (TRANSDUCERS & EUROSENSORS XXVII), IEEE, 16. Juni 2013 (2013-06-16), Seiten 1907-1910, XP032499326, DOI: 10.1109/TRANSDUCERS.2013.6627165 [gefunden am 2013-10-09]
- HUANG CONGLIANG ET AL: "Thermal conductivity of silica nanoparticle powder: Measurement and theoretical analysis", THE EUROPEAN PHYSICAL JOURNAL PLUS, SPRINGER BERLIN HEIDELBERG, BERLIN/HEIDELBERG, Bd. 130, Nr. 12, 4. Dezember 2015 (2015-12-04), Seiten 1-6, XP035566906, DOI: 10.1140/EPJP/I2015-15239-5 [gefunden am 2015-12-04]

## Beschreibung

### Gebiet der Erfindung

Die vorliegende Erfindung betrifft ein Mikrosystem, das einen porösen Wärmeisolationskörper umfasst, der aus Partikeln geringer Wärmeleitfähigkeit zusammengesetzt ist.

### Stand der Technik

Mikroelektromechanische Sensoren (MEMS-Sensoren), die auf thermischen Messprinzipien beruhen, wie Durchflussmesser und Gassensoren, gewinnen zunehmend an Bedeutung für die unterschiedlichsten Anwendungen. Während Durchflussmesser bisher vor allem für die Überwachung von gasförmigen und flüssigen Medien in technischen Anlagen verwendet wurden, dienten Gassensoren der Detektion brennbarer bzw. explosiver Gase. Dazu gehören flüchtige organische Verbindungen (Heizgase, Methan, und Ethanol), giftiger Gase (CO, NOₓ, H₂S) oder Rauchgase. Mittlerweile gibt es jedoch auch viele Konsumeranwendungen, z. B. die CO₂-Überwachung in Konferenzräumen, die Detektion von Gerüchen, wie Zigarettenrauch oder Küchendünste.

Kalorimetrische Gassensoren und Durchflussmesser beruhen auf sogenannten Hotplates. Ganz allgemein besteht eine Hotplate aus einem Dünnfilm-Heizelement auf einer thermisch isolierten Struktur aus einem Material mit möglichst schlechter Wärmeleitfähigkeit. Nachfolgend wird der Begriff "Hotplate" synonym für "Heizelement" verwendet. Durchflussmesser erfordern Temperaturen bis 200°C. Oftmals sind mehrere Heizelemente bzw. Temperatursensoren auf der Membran angeordnet. Bei Gassensoren liegt die Betriebstemperatur bei 300-600°C. Je nach Funktionsprinzip kann die Hotplate mit weiteren Beschichtungen versehen sein. Das Hauptproblem kalorimetrischer Bauelemente ist der Energieverbrauch zum Halten der Betriebstemperatur. Insbesondere für mobile Anwendungen ist eine Minimierung des Leistungsbedarfs von großer Bedeutung. Ein weiteres Problem ist die Fragilität der freitragenden, die Hotplate bildenden MEMS-Struktur. Die Hotplate kann sich auf einer geschlossenen Membran aus Siliziumoxid und -nitrid befinden. Letztere wird durch Ätzen des Siliziums von der Rückseite des Substrates erzeugt. Alternativ dazu können freistehende Trägerstrukturen für die Hotplate verwendet werden. Freistehende Hotplate-Strukturen erhält man durch Herausätzen des darunter befindlichen Siliziums von der Vorderseite des Substrats. Beide Varianten haben Vor- und Nachteile. Bei membranbasierten Hotplates können Konvektionseffekte oder Druckschwankungen im Volumen unterhalb der Membran die Messung verfälschen sowie Druckstöße die Struktur zerstören. Bei den freistehenden Hotplate-Strukturen, die einen offenen Kanal überspannen und auf beiden Seiten vom Medium umströmt werden, wird die thermische Isolation zum Substrat vom Medium beeinflusst. Solche Flussmesser sind daher im Gegensatz zu den membranbasierten Bauelementen für Flüssigkeiten nicht geeignet.

Um eine Temperatur von 400°C permanent zu halten, benötigen herkömmliche Sensoren eine Leistung von etwa 15 mW zum Halten der Betriebstemperatur. Werden dieselben Sensoren nur für 2-3 Sekunden pro Minute eingeschaltet, verringert sich der Energieverbrauch deutlich. Das ist jedoch für bestimmte Anwendungen immer noch zu hoch.

Der hohe Leistungsverbrauch resultiert aus der Spezifik von mikromechanischen Strukturen. Da das Fläche/Querschnitt-Verhältnis des beheizten Bereichs sehr hoch ist, werden die Wärmeverluste im Unterschied zu makroskopischen Körpern nicht durch Wärmeleitung im Volumen, sondern durch den Wärmetransfer zum Umgebungsmedium dominiert. Die Wärmeleitung durch die Membran ist nur für etwa 40% der Verluste verantwortlich und hängt zudem aufgrund deren sehr geringer Dicke nur wenig vom verwendeten Material ab. Die Wärmeverluste über die Umgebungsluft betragen hingegen etwa 60%. Dabei geht ein Großteil davon über die Kavität unterhalb des Sensors verloren. Folglich ist eine weitere Verringerung der Wärmeverluste nur durch Design- und Materialoptimierung einer herkömmlichen Sensorstruktur kaum zu erzielen.

### Durch die Erfindung zu lösende Aufgaben

Der Stand der Technik bietet keine zufriedenstellende Lösung des Hauptproblems kalorimetrischer Bauelemente an. Dieses Hauptproblem ist der Energieverbrauch zum Halten der Betriebstemperatur. Ein weiteres Problem, das im Stand der Technik nicht zufriedenstellend gelöst wird, ist die Fragilität von freitragenden Strukturen in Mikrosystemen.

Daher ist es die Aufgabe der vorliegenden Erfindung, ein Mikrosystem bereitzustellen, bei dem die Aufgabe der Wärmeisolierung und der Stabilisierung gelöst wird.

### Zusammenfassende Darstellung der Erfindung

Die vorliegende Erfindung beschreibt eine neuartige Möglichkeit zur thermischen Isolation von Mikrosystemen, wie MEMS-Bauelementen, die sowohl eine Verringerung des Energieverbrauchs als auch eine Erhöhung deren mechanischer Stabilität bewirkt.

Die gestellte Aufgabe wurde durch Bereitstellen eines Mikrosystems gelöst, das einen porösen Wärmeisolationskörper aufweist.

Der Gegenstand der vorliegenden Erfindung ist in den Patentansprüchen definiert.

### Vorteile und Anwendung der Erfindung

Die erfindungsgemäßen Mikrosysteme vereinen die Möglichkeiten herkömmlicher Superisolationen mit mikrotechnischen Herstellungsverfahren.

Beispielsweise bietet die thermische Isolation einer Hotplate mittels eines porösen Körpers entscheidende Vorteile im Vergleich zu herkömmlichen MEMS-Bauelementen.

Ein erster Vorteil ist die mechanische Versteifung der Hotplate. Die Einsatzmöglichkeiten herkömmlicher membranbasierter Bauelemente werden erheblich eingeschränkt durch die Fragilität der dünnen Membran, die leicht beschädigt werden kann z.B. durch Druckstöße, Partikelbeschuss oder thermisch induzierten Stress bei Betriebstemperatur.

Ein zweiter Vorteil im Vergleich zu Flusssensoren des Standes der Technik ist, dass durch die poröse Struktur Konvektionseffekte und Druckschwankungen in der Kavität unterhalb der Sensormembran, die zu einer Verfälschung der Messung führen können, unterdrückt werden.

Ein dritter Vorteil ist, dass ein Silizium-Substrat mit eingebetteten porösen Strukturen wie ein normaler Wafer weiterbearbeitet werden kann. Mittels etablierter Techniken der Halbleitertechnologie können leicht vertikale elektrische Durchführungen (Through Silicon Vias, TSV) zur räumlichen Trennung der elektrischen Anschlüsse vom Sensorbereich integriert werden. Durch die Verwendung solcher Durchführungen wird die Strömung des Mediums über die Sensoroberfläche nahezu nicht verfälscht.

Die verringerte Heizleistung dank der verbesserten thermischen Isolation in Kombination mit einer mechanischen Stabilisierung der Sensorstruktur und einer räumlichen Trennung der elektrischen Anschlüsse ermöglicht die Erschließung neuer Anwendungsgebiete.

Wenn die erfindungsgemäßen Mikrosysteme Gassensoren sind, können diese wesentlich einfacher in Arrays für elektronische Nasen oder in sogenannten "sensor skins" verwendet werden. Insbesondere letztere setzen eine flache Bauweise und die Möglichkeit einer oberflächenbündigen Montage voraus.

Flusssensoren könnten für drahtlose Sensorknoten zur Überwachung von Trinkwasserleitungen in Versorgungsnetzen zur Echtzeit-Detektion von Leckagen, Verbrauch oder einer unbefugten Nutzung verwendet werden. Möglich sind auch Strömungsmessungen auf der Außenhaut von Fahr- und Flugzeugen oder in Turbinen. Die Möglichkeit einer einfachen, schlüssigen Integration in die Wandung beliebig geformter Rohre oder Leitungen würde zudem den massenhaften Einsatz in Haushaltsgeräten zur Durchflussmessung erlauben (Kaffeemaschinen, Klimaanlagen, Duschen, Toilettenspülungen usw.).

Bei einer bestimmten Größe der in dem Wärmeisolationskörper enthaltenen Partikel (2 µm - 20 µm) streut außerdem das IR-Licht das von den erwärmten Flächen ausgesendet wird, so dass auch die Verluste aufgrund von Strahlungstransporten minimiert wird.

Die hier beschriebene Technologie ist nicht auf die Herstellung von Hotplates für Chemosensoren oder thermischen Flusssensoren beschränkt, sondern immer dann von Vorteil, wenn auf einem sehr engen Bauraum eine möglichst gute thermische Isolation benötigt wird.

Nahliegend ist z.B. der Aufbau miniaturisierter thermischer IR-Quellen die ebenfalls bei Temperaturen von einigen 100°C betrieben werden müssen.

Aber auch für die Konstruktion von miniaturisierten Atomuhren, Gyroskopen oder Magnetometer ist diese Technik geeignet, denn hier müssen kleinste Gaszellen auf eine Temperatur von über 100°C gehalten werden, um das darin enthalte Alkalimetall (in der Regel Rubidium) in einem Gasförmigen Zustand zu erhalten.

Nicht zuletzt spielt eine möglichst gute thermische Isolation eine Schlüsselrolle für miniaturisierte Wärmekraftmaschinen, um die Verluste aufgrund von Wärmeleitung zu verringern und die Gesamteffizienz zu steigern. Als Beispiel sei hier auf die Konstruktion von pyroelektrischen Harvestern verwiesen.

### Beschreibung der Figuren

Figuren 1a und 1b zeigen den schematischen Querschnitt durch ein erfindungsgemäßes Mikrosystem. Es ist eine Hotplate-Anordnung, bei der die rückseitige Kavität nach Fertigstellung des MEMS-Bauelements mit einem porösen Körper verfüllt wurde. In Fig. 1a sind alle Partikel beschichtet, in Fig. 1b ist nur ein Teil der Partikel beschichtet.
Figuren 2a bis 2c zeigen den schematischen Querschnitt durch ein erfindungsgemäßes Mikrosystem mit einer Hotplate-Anordnung, die erst nach Erzeugung und Planarisierung der thermisch isolierenden porösen Bereiche im Substrat realisiert wird.
Figuren 3a und 3b zeigen schematische Darstellungen der Aufbau- und Verbindungstechnik für einen Flussmesser mit konventionellem Aufbau (a) und erfindungsgemäßem Aufbau (b). Letzterer basiert auf einem eingebetteten, porösen Körper zur thermischen Isolation und weist vertikale elektrische Durchführungen (TSV) auf.
Figuren 4a und 4b zeigen schematische Querschnitte durch zwei mögliche erfindungsgemäße Anordnungen, die auf einer thermischen Isolation aus verfestigten Partikeln basieren und bei denen die elektrischen Anschlüsse vom Sensorbereich räumlich getrennt sind. Dementsprechend befindet sich das zu überwachende Medium in (a) auf der Oberseite und in (b) auf der Unterseite des Sensorchips.
Figur 5 zeigt ein Ausführungsbeispiel, bei dem zusätzlich ein isolierter Reflektor aus einer dünnen Goldschicht hilft, die Verluste aufgrund von Strahlung zu verringern. Um wiederum dessen Wärmeabfuhr zu verringern, ist auch dieser Reflektor thermisch isoliert und durch eine evakuierte Kavität auf dessen Rückseite isoliert, die ebenfalls mit Partikeln gefüllt ist. Diese Ausführung ist vor allem für Hotplates mit hohen Temperaturen > 500°C interessant.
Figuren 6a bis 6e veranschaulichen ein Verfahren zur Herstellung eines erfindungsgemäßen Mikrosystems.
Figuren 7a bis 7e veranschaulichen ein Verfahren zur Herstellung eines erfindungsgemäßen Mikrosystems.
Figuren 8a bis 8f veranschaulichen ein Verfahren zur Herstellung eines erfindungsgemäßen Mikrosystems.
Figuren 9a und 9b zeigen den schematischen Querschnitt durch ein erfindungsgemäßes Mikrosystem.

### Ausführungsformen der Erfindung

### Mikrosystem

Das erfindungsgemäße Mikrosystem hat Abmessungen im Bereich von Mikrometern bis Millimetern. Vorzugsweise liegen die Abmessungen im Bereich von 1 µm bis 10 mm, stärker bevorzugt im Bereich von 10 µm bis 5 mm, noch stärker bevorzugt im Bereich von 50 µm bis 2 mm.

Das Mikrosystem kann eine MEMS-Struktur sein.

Insbesondere kann die MEMS-Struktur ein kalorimetrisches MEMS-Bauelement sein, das auf einer Hotplate basiert, z. B. ein Durchflussmesser, ein katalytischer Gassensor, ein MOS-Gassensor (MOS bedeutet halbleitendes Metalloxid) oder ein Strahlungssensor (Bolometer).

### Wärmeisolationskörper

Der Wärmeisolationskörper, der im Folgenden manchmal auch einfach als "poröse Struktur" oder "poröser Körper" bezeichnet wird, ist in dem Mikrosystem so angeordnet, dass er der Wärmeisolierung dient. Dazu befindet sich der Wärmeisolationskörper zwischen zwei Elementen, die einen Temperaturunterschied aufweisen, zum Beispiel zwischen zwei Elementen des erfindungsgemäßen Mikrosystems. Alternativ oder zusätzlich dazu ist der Wärmeisolationskörper zwischen einem Element des Mikrosystems und der Umgebung angeordnet. Die Umgebung kann ein Element einer anderen Struktur oder das Umgebungsfluid, also eine Flüssigkeit oder ein Gas, sein.

Des Weiteren kann der Wärmeisolationskörper in dem Raum zwischen mindestens zwei Elementen des Mikrosystems oder in einer Aussparung bzw. Kavität eines einzigen Elements des Mikrosystems angeordnet sein.

Der Wärmeisolationskörper ist in einer Ausführungsform allseitig von anderen Strukturen umschlossen, wobei diese Strukturen vorzugsweise Elemente des erfindungsgemäßen Mikrosystems sind. Dieser allseitige Einschluss des Wärmeisolationskörpers ermöglicht, dass ein Anteil der Partikel unverfestigt, also lose vorliegen kann. Bevorzugt ist der Wärmeisolationskörper unter Einsatz einer Versiegelungsschicht (9) abgeschlossen.

Der Wärmeisolationskörper ist in einer anderen Ausführungsform nicht allseitig von anderen Strukturen umschlossen. In diesem Fall muss der Wärmeisolationskörper zumindest auf der Seite, die nicht von einer anderen Struktur umschlossen ist, einen Bereich mit verfestigten Partikeln derart aufweisen, dass dieser einen mit den anderen Strukturen schlüssig verbundenen Abschluss bildet.

In jedem Fall sind die Strukturen so ausgestaltet und miteinander verbunden, dass ein abgeschlossener Raum entsteht, aus dem vorhandene lose Partikel nicht heraustreten und somit dem Wärmeisolationskörper verlorengehen können.

### Partikel

Die Partikel haben eine mittlere Größe von 10 nm bis 100 µm, bevorzugt von 100 nm bis 30 µm, stärker bevorzugt von 1 µm bis 20 µm.

Das die Partikel bildende Material hat bevorzugt eine geringe Wärmeleitfähigkeit. Es kann aber auch ein Gemisch von Partikeln aus verschiedenen Materialien verwendet werden, wobei das eine Material eine relativ hohe thermische Leitfähigkeit von z.B. 40 W/m.K hat. Da sich die Partikel nur punktuell berühren, ist die effektive Wärmeleitfähigkeit eines entsprechenden porösen Körpers geringer.

Die Partikel können beispielsweise aus Siliziumoxid bestehen, dass eine Wärmeleitfähigkeit von etwa 1,2 bis 1,4 W/(m·K) aufweist. Andere Metalloxide mit geringer thermischer Leitfähigkeit sind z.B. Yttriumoxid (Y₂O₃)oder Zirkoniumoxid (Zirkonia, ZrO₂).

Aluminiumoxid hat unter Standardbedingungen eine Wärmeleitfähigkeit von 35,6-39 W·m⁻¹·K⁻¹ (einkristalliner Korund: 40 W·m⁻¹·K⁻¹, dichte Keramik mit 96% Al₂O₃ ca. 25 W·m⁻¹·K⁻¹), der mit sinkender Temperatur stark ansteigt und mit steigender Temperatur bei 1000°C auf etwa 5 W·m⁻¹·K⁻¹ absinkt.

Glas hat je nach Zusammensetzung unterschiedliche Wärmeleitfähigkeit, beispielsweise hat Zerodur 1,46 W/(m·K) und Kalk-Natron-Glas 0,80 W/(m·K).

Beispielhafte Metalle haben folgende Wärmeleitfähigkeiten: Wolfram 167 W/(m·K), Ni 85 W/(m·K), Eisen 80 W/(m·K), Zinn 67 W/(m·K), Tantal 54 W/(m·K), Titan 22 W/(m·K), Bismuth 8,4 W/(m·K).

Typische Wärmedämmstoffe wie Kaolin, Kreide und Talkum weisen eine Wärmeleitfähigkeit von unter 2 W/(m·K) auf.

Es können natürlich auch organische Polymere verwendet werden, beispielsweise: Polyurethan kompakt (PUR) 0,245 W/(m·K); Polytetrafluorethylen (PTFE) 0,25 W/(m·K); Polyvinylchlorid (PVC) 0,17; Polypropylen (PP) 0,23 W/(m·K); Polycarbonat 0,20 W/(m·K); Epoxidharz (EP) 0,20 W/(m·K); Polymethylmethacrylat (PMMA, Plexiglas) 0,19 W/(m·K); Polysiloxane (Silikon) 0,2...0,3 W/(m·K).

Die Partikel weisen bevorzugt einen relativ kleinen Durchmesser von weniger als 20 µm, vorzugsweise weniger als 10 µm und besonders vorzugsweise weniger als 5 µm auf.

Um eine Beschädigung des Trägerelements und/oder der Partikel beim Beschichten zu vermeiden, ist es vorteilhaft, wenn die Partikel und das Substrat bis zu einer Temperatur von mindestens 60°C, vorzugsweise 150°C oder 300°C, wärmebeständig sind. Je höher die Wärmebeständigkeit, desto weniger Einschränkungen ergeben sich hinsichtlich der verwendbaren Beschichtungsverfahren. Zugleich ermöglicht die hohe Wärmebeständigkeit eine schnellere Durchführung des Verfahrens, ohne dass eine Beschädigung der Partikel und/oder des Trägerelements durch Überhitzen zu befürchten ist.

Um einen Verlust bzw. eine Verringerung der porösen Eigenschaften zu vermeiden, werden die Partikel beim Verbinden derselben vorzugsweise im Wesentlichen nicht irreversibel verformt.

In einer besonders bevorzugten Ausführungsform wird ein Partikelgemisch mit Partikeln aus mindestens zwei verschiedenen Materialien eingebracht. Die Materialien unterscheiden sich vorzugsweise hinsichtlich mindestens einer physikalischen oder chemischen Eigenschaft. Beispielsweise kann eine Härte, eine elektrische Leitfähigkeit, eine thermische Leitfähigkeit, ein thermischer Ausdehnungskoeffizient und/oder die elektrochemischen Parameter der Partikel unterschiedlich gewählt werden. Durch Verwendung unterschiedlicher Materialien mit auch unterschiedlichen Mischungsverhältnissen und gegebenenfalls unterschiedlichen chemischen und physikalischen Eigenschaften können die Eigenschaften der dreidimensionalen Struktur präzise und zuverlässig an gewünschte Vorgaben angepasst und eingestellt werden.

Beispielsweise kann ein thermischer Ausdehnungskoeffizient der Partikel bzw. des Partikelgemischs an den thermischen Ausdehnungskoeffizienten des Trägerelements angepasst werden. Ebenso kann der thermische Ausdehnungskoeffizient der Partikel bzw. des Partikelgemischs auch an ein Bauteil angepasst werden, in dem die verbundenen Partikel angeordnet werden sollen.

Die Partikel können auch eine Mischung verschiedener Materialien in Partikelform sein. Beispielsweise können Partikel verwendet werden, um den effektiven thermischen Ausdehnungskoeffizienten anzupassen.

Unter Umständen ist auch vorteilhaft den Partikeln kurze Fasern beizufügen, um die mechanische Stabilität des gesamten Gefüges zu erhöhen.

Je nach vorgesehenem Anwendungszweck kann es daher vorteilhaft sein die Partikelgröße der erwarteten Arbeitstemperatur des Sensorelements anzupassen.

### Wärmeleitfähigkeit

Die Wärmeleitfähigkeit der Partikel ist weniger als 10 W/(m·K), vorzugsweise weniger 5 W/(m·K), stärker bevorzugt weniger als 3 W/(m·K) und noch stärker bevorzugt weniger als 1 W/(m·K). Die Angabe der Wärmeleitfähigkeit bezieht sich auf die Messung bei 20°C, 1013 hPa und 50% relative Luftfeuchtigkeit.

Der Wärmeleitfähigkeitswert der Partikel kann sich auch auf ein Gemisch von Partikeln aus unterschiedlichen Materialien mit einer Gesamtleitfähigkeit von weniger als 10 W/(m·K) oder einer Gesamtleitfähigkeit innerhalb der genannten bevorzugten Bereiche beziehen.

### Beschichtung

In einer bevorzugten Ausführungsform ist mindestens ein Anteil der Partikel mittels einer Beschichtung miteinander verbunden.

Vorzugsweise ist dieser Anteil mindestens 5%, mindestens 10%, mindestens 20%, mindestens 50% oder mindestens 90%.

In einer weiter bevorzugten Ausführungsform sind mindestens 95%, stärker bevorzugt mindestens 98% und noch stärker bevorzugt alle Partikel mittels einer Beschichtung miteinander verbunden.

In einer Ausführungsform ist der Wärmeisolationskörper von einer allseitigen Wandung umgeben. Diese Wandung kann einen Raum umgeben, der zunächst mit einer Öffnung zum Einfüllen der Partikel versehen ist. Die Öffnung kann dann verschlossen werden, indem mittels Beschichtung der Partikel zumindest an der Öffnung ein fester Überzug gebildet wird. Dieser Überzug macht dann einen Anteil von 3 bis 50%, vorzugsweise 5 bis 30% und stärker bevorzugt 10 bis 20% der Gesamtmenge der Partikel aus.

### Wärmeisolierung

Der hier verwendete Ausdruck Wärmeisolierung bedeutet die Verringerung der Wärmeübertragung durch Wärmeleitung, vorzugsweise die Verringerung der Wärmeübertragung durch Wärmeleitung und mindestens eine unter Wärmestrahlung und Konvektion ausgewählte Wärmeübertragungsart.

Die Verringerung der Wärmeleitung wird dadurch erreicht, dass ein Material geringer Wärmeleitfähigkeit eingesetzt wird.

Die Verringerung der Konvektion wird dadurch erreicht, dass ein Material mit verbundenen Partikeln eingesetzt wird. Dieses Material enthält den oder besteht aus dem in dem Mikrosystem enthaltenen Wärmeisolationskörper.

### Unterdruck

Der Wärmeisolationskörper ist mit Unterdruck beaufschlagt. Das heißt, dass der Druck darin geringer ist als der Druck außerhalb des Körpers. Vorzugsweise ist in mindestens einem Teil des wärmeisolierenden Körpers, in dem sich Poren befinden, der Druck verringert.

Der Ausdruck "Unterdruck" umfasst auch Vakuum.

Der Unterdruck ist weniger als 1013 hPa, vorzugsweise weniger 1000 hPa, stärker bevorzugt weniger als 700 hPa, noch stärker bevorzugt weniger als 500 hPa.

Am stärksten bevorzugt ist ein Unterdruck im Bereich von 10⁻³ bis 300 hPa, oder besonders bevorzugt im Bereich von 1 bis 100 hPa.

Der hier verwendete Ausdruck "Vakuum" bedeutet, dass der Druck weniger als 300 hPa, vorzugsweise weniger als 100 hPa, stärker bevorzugt weniger als 10 hPa und noch stärker bevorzugt weniger als 1 hPa beträgt.

Der Unterdruck hat den Vorteil, dass die Wärmeleitfähigkeit des Wärmeisolationskörpers zusätzlich verringert wird.

### Porosität

Der in dem erfindungsgemäßen Mikrosystem enthaltene Wärmeisolationskörper ist porös, das heißt, er weist zwischen den Partikeln eine Vielzahl von Poren auf.

Die Poren sind mit Gas gefüllt bzw. im Vakuum leer.

Die Porosität gibt das Verhältnis von Hohlraumvolumen zu Gesamtvolumen des Wärmeisolationskörpers an. Die Porosität des Wärmeisolationskörpers ist aus Gewichtsgründen hoch. Da ein Unterdruck bzw. Vakuum in dem Wärmeisolationskörper gegeben ist, führt eine hohe Porosität zu einem geringen Gewicht bei gleichzeitiger guter Wärmeisolation.

Der Porositätsbereich ist 1 bis 70%. Andere Porositätsbereiche sind 5 bis 40% oder 10 bis 50%. Andere Beispiele sind Porositäten von mehr als 5%, mehr als 10%, mehr als 20%, mehr als 30%, und mehr als 50%; und jeder dieser Werte verbunden mit einer Obergrenze von 70%.

Die Porosität kann gesteuert werden. Eine Verringerung der Porosität ist durch zusätzliche Beschichtung möglich. Höhere Porositäten können erzielt werden, wenn die Partikel an sich schon porös sind oder z.B. eine verästelte Form aufweisen.

### Versiegelungsschicht

Je nach Ausführungsform kann auf die Anordnung aus Partikeln und Trägerelement zumindest teilweise eine Versiegelungsschicht (9), auch Deckschicht genannt, aufgebracht werden, die oberflächennahe Hohlräume im Wesentlichen vollständig verschließt und/oder eine geschlossene Schicht auf einer obersten Lage der Partikel bildet. Die Deckschicht wird vorzugsweise nachfolgend, beispielsweise durch Schleifen oder Polieren, planarisiert. Dadurch kann eine besonders glatte Schicht erzeugt werden.

In einer Ausführungsform ist der Wärmeisolationskörper von einer allseitigen Wandung umgeben. Diese Wandung kann einen Raum umgeben, der zunächst mit einer Öffnung zum Einfüllen der Partikel versehen ist. Die Öffnung kann dann verschlossen werden, indem eine Versiegelungsschicht (9) aufgebracht wird.

Die Versiegelungsschicht wird aufgebracht, nachdem optional ein Anteil oder die Gesamtheit der Partikel mittels Beschichtung verbunden worden ist.

### Erstes bevorzugtes Verfahren zur Herstellung der porösen Struktur

In der vorliegenden Erfindung wird der Wärmeisolationskörper (poröse Struktur) vorzugsweise dadurch hergestellt, dass eine Vielzahl von Partikeln in einer Aussparung angeordnet wird, so dass eine poröse Struktur entsteht.

Ein allgemeines Verfahren zur Herstellung von porösen Strukturen wird in DE 10 2011 010 899 A1 beschrieben.

Darin werden zunächst Partikel auf oder in ein Trägerelement ein- bzw. aufgebracht. Zwischen den Partikeln wird eine Vielzahl zumindest teilweise miteinander verbundener Hohlräume gebildet. Die Hohlräume werden auch Poren genannt. Die Partikel treten hierbei an Berührungspunkten miteinander in Kontakt. Das Ein- bzw. Auftragen kann beispielsweise durch Rakeln erfolgen. Die Partikel können beliebige Form und Größe aufweisen.

Nach dem Ein- oder Aufbringen der Partikel werden diese vorzugsweise miteinander verbunden. Diese Verbindung erfolgt an den Berührungspunkten. Hierzu werden die Partikel beschichtet, wobei die Hohlräume zumindest teilweise von der beim Beschichten erzeugten Schicht durchdrungen werden.

Je nach Ausführungsform können die Hohlräume beim Beschichten offen bleiben, d. h., durch die Beschichtung wird zwar eine Verbindung zwischen den Partikeln bewirkt, der Großteil der Hohlräume zwischen den Partikeln bleibt hierbei jedoch miteinander verbunden. Alternativ kann zumindest ein Teil der Hohlräume von der Schicht verschlossen werden, so dass die Hohlräume geschlossene Poren bilden.

Ebenso ist es möglich, dass nur ein Teil der Partikel beim Beschichten verbunden wird, das heißt es ist sowohl ein teilweises als auch ein vollständiges Durchdringen der Hohlräume mit der beim Beschichten erzeugten Schicht möglich.

Werden im Wesentlichen alle Partikel miteinander verbunden und somit im Wesentlichen alle Hohlräume durchdrungen, bildet sich auch auf dem Bereich des Trägerelements eine Schicht, in dem die Partikel auf- bzw. eingebracht sind.

Je nach Anwendungsgebiet können elektrisch leitende oder nichtleitende Partikel verwendet werden. Auch für die Beschichtung können elektrisch leitende oder nichtleitende Materialien verwendet werden.

Ein relativ unkompliziertes und gleichmäßiges Auftragen der Beschichtung ist mittels eines CVD-Verfahrens (chemical vapor deposition) und insbesondere mittels einer Atomlagenabscheidung möglich. Bei einer Atomlagenabscheidung werden wechselweise zwei verschiedene Komponenten im gasförmigen Zustand eingeleitet, wobei sich diese jeweils an der Oberfläche der Partikel bzw. des Trägerelements anlagern. Bei jedem Anlagerungsvorgang wird eine im Wesentlichen durchgängige ein Atom dicke Schicht gebildet. Hierdurch wird eine besonders gleichmäßige Schicht erzeugt. Eine Schichtdicke wird hierbei hauptsächlich darüber eingestellt, wie oft zwischen einem Einbringen einer ersten Komponente und einem Einbringen einer zweiten Komponente gewechselt wird.

Eine Dicke der aufgebrachten Schicht kann besonders bevorzugt zwischen einer Atomlage und 5 µm, zwischen 5 nm und 1 µm oder zwischen 50 nm und 300 nm betragen. Geringe Schichtdicken haben hierbei den Vorteil, dass sie innerhalb von kurzer Zeit hergestellt werden können. Durch Schichtdicken im oberen Bereich der angegebenen Spannen hingegen wird eine besonders feste und zuverlässige Verbindung ermöglicht.

Durch die Beschichtung wird vorzugsweise ein vernachlässigbar geringer Anteil am Volumen der beim Ein- bzw. Aufbringen der Partikel gebildeten Hohlräume eingenommen. Ein Volumen der Schicht kann bevorzugt weniger als 1% eines Volumens der Hohlräume betragen.

Je nach Ausführungsform werden entweder nur ein Teil der Partikel oder im Wesentlichen alle ein- bzw. aufgebrachten Partikel miteinander verbunden. Ein Verbinden im Wesentlichen aller Partikel ist insbesondere dann vorteilhaft, wenn eine Struktur des Trägerelements abgeformt werden soll.

Die Partikel können vor dem Beschichten in losem Kontakt miteinander angeordnet sein. Somit sind vor dem Aufbringen der Beschichtung keinerlei zusätzliche Verfahrensschritte zum Herstellen einer Verbindung zwischen den Partikeln notwendig.

Als besonders geeignete Substrate haben sich Substrate aus Silizium, Glas oder Keramik herausgestellt. Das Substrat kann beispielsweise als Wafer oder Platte ausgebildet sein. Siliziumwafer sind hierbei besonders für eine Anwendung im Mikroelektronikbereich geeignet.

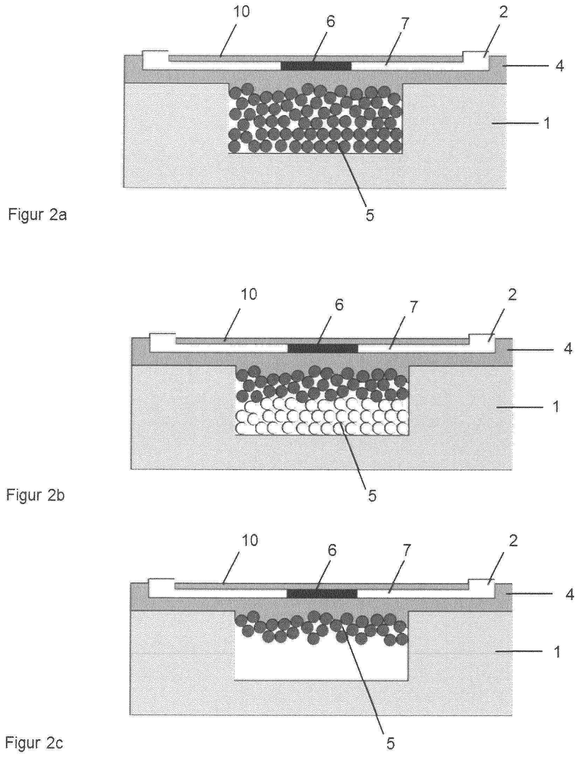

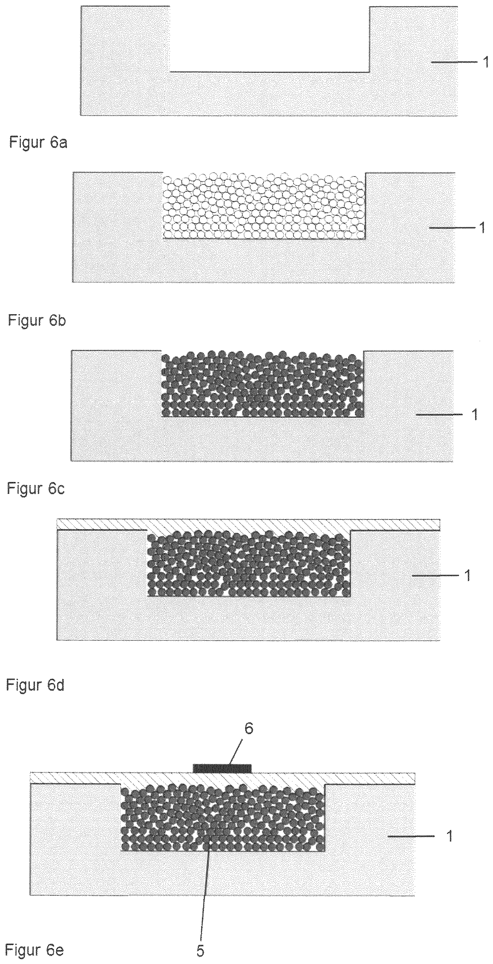

Anhand von Fig. 2a und Fig. 6a bis 6e wird eine Ausführungsform des Verfahrens veranschaulicht.

In einem ersten Verfahrensschritt wird hierzu ein Substrat 1 bereitgestellt, in das eine Aussparung 20 eingebracht wird. Es werden Partikel in die Aussparung 20 eingefüllt, z. B. durch Aufrieseln der Partikel und/oder durch Rakeln. Die Anordnung und Ausrichtung der Partikel zueinander ist hierbei willkürlich.

In einem nachfolgenden Verfahrensschritt wird eine Beschichtung mit einer Dicke von 10 nm bis 300 nm durch ein CVD (chemical vapor deposition)-Verfahren, genauer durch Atomlagenabscheidung, aufgebracht. Durch das Beschichtungsmaterial wird nicht nur eine Schicht am Boden der Vertiefung bzw. neben der Vertiefung gebildet, sondern es lagert sich auch an den Partikeln an. Da die Partikel nach dem Einfüllen in die Aussparung 20 an Berührungspunkten in Kontakt miteinander stehen, führt das Anlagern des Beschichtungsmaterials zu einer Verbindung der Partikel untereinander, so dass sie einen zusammenhängenden Körper aus verfestigten Partikeln bilden. Beim Beschichten werden die Partikel sowie das Substratelement auf etwa 60°C bis 300°C erwärmt. In entsprechender Weise wird das Material für Partikel und Substratelement temperaturresistent ausgelegt.

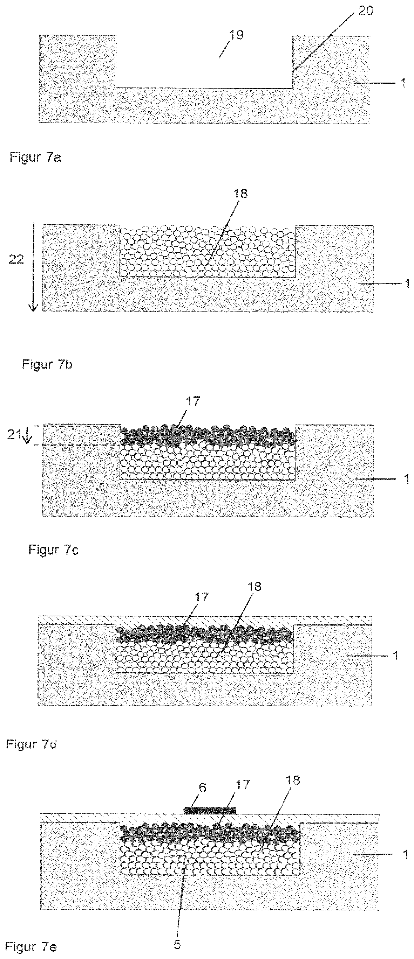

Abb. 2b zeigt eine weitere Variante, bei der die Partikel nicht bis zum Boden der Vertiefung verfestigt werden. Der dazu passende Prozess ist in Fig. 7a bis 7e dargestellt.

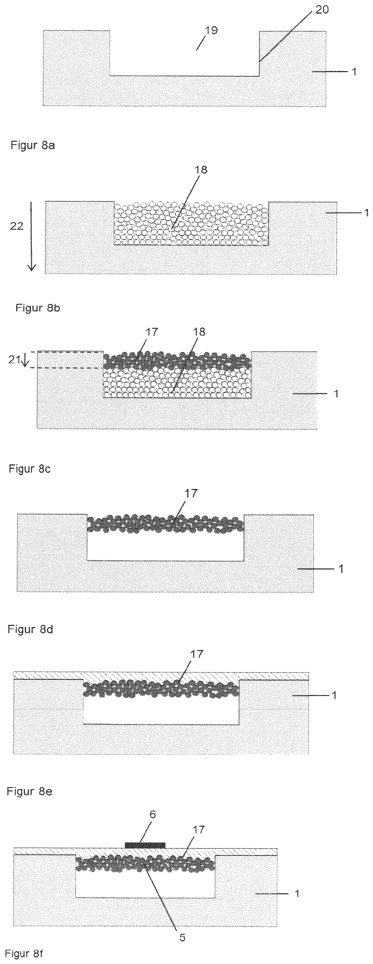

Abb. 2c zeigt eine dritte Variante, bei der die gemäß Abb. 2a lose gebliebenen Partikel vor dem Versiegeln selektiv herausgeätzt werden. Das kann mittels eines passenden Ätzgases erfolgen, durch die Poren zwischen den verfestigten Partikeln 17 hindurch. Bestehen die unverfestigten Partikel 18 z.B. aus Siliziumdioxid können sie in XeF₂-Gasphase entfernt werden. Der Prozess ist in Fig. 8a bis 8f dargestellt.

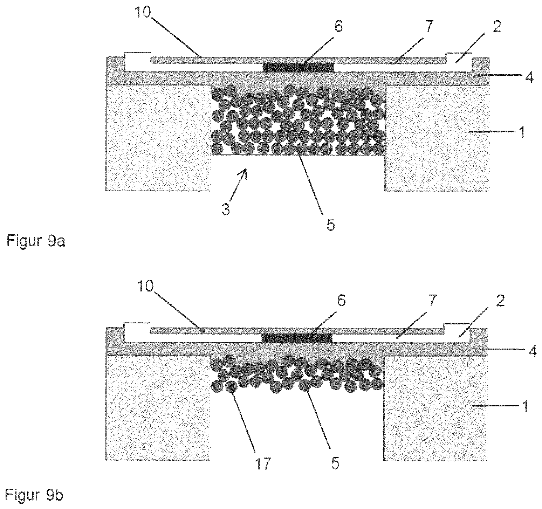

Ein weiteres Ausführungsbeispiel des erfindungsgemäßen Verfahrens wird nachfolgend erläutert (Fig. 9a und 9b). Bei dieser Ausführungsform wird zunächst ein Substrat mit einer verfüllten Aussparung 20, wie in Zusammenhang mit Fig. 2a oder 2b beschrieben, hergestellt. In diesem Ausführungsbeispiel können die Prozessparameter des ALD-Verfahrens jedoch auch so gewählt werden, dass die ALD-Schicht die Hohlräume nicht vollständig durchdringt, d. h. es müssen nicht unbedingt alle Partikel miteinander verbunden sein. Anschließend wird das Substrat 1 teilweise entfernt, so dass die verdichteten Partikel lediglich am Rand am Substrat befestigt sind, während sie in einem mittleren Bereich eine freitragende Membran bilden. Sollten einige Partikel nicht mit verbunden sein, werden sie in diesem Verfahrensschritt mit entfernt. Die Dicke der freitragenden Membran, die beispielsweise etwa 40 µm betragen kann, wird dann durch eine Eindringtiefe der ALD-Schicht in die mit Partikeln gefüllte Aussparung 20 bestimmt. Diese kann, insbesondere wenn im Wesentlichen alle Partikel verbunden wurden und das Beschichtungsmaterial die Hohlräume bis zum Boden der Aussparung 20 durchdrungen hat, auf ihrer Rückseite noch mit der im Wesentlichen geschlossenen ALD-Schicht, die sich auf der Oberfläche des Substrats 1 beim Aufbringen der Beschichtung gebildet hat, bedeckt sein.

Diese ALD-Schicht wird, soweit vorhanden, im nachfolgenden Verfahrensschritt entfernt. Das Entfernen kann beispielsweise mittels lonenstrahlätzen erfolgen.

Alternativ wird die ALD-Hülle (3) beibehalten und von unten mit einer Versiegelungsschicht bedeckt. Dadurch ist der poröse Körper gemäß Fig. 9a unter Vakuum (im Unterschied zu Fig. 9b).

### Zweites bevorzugtes Verfahren zur Herstellung der porösen Struktur

In diesem Verfahren wird der Wärmeisolationskörper vorzugsweise dadurch hergestellt, dass eine Vielzahl von Partikeln in einer Aussparung angeordnet wird, so dass eine poröse Struktur entsteht.

Ein Verbinden eines Teils der Partikel ermöglicht ein Verhindern eines Entweichens der restlichen Partikel, so dass der Betrieb des Reaktors reproduzierbar und dauerhaft ermöglicht ist.

Gemäß einem Ausführungsbeispiel umfasst eine Vorrichtung ein Substrat, das eine Aussparung aufweist und eine Vielzahl von Partikeln, die in der Aussparung angeordnet sind.

Der im Folgenden verwendete Ausdruck "Vorrichtung" kann das erfindungsgemäße Mikrosystem sein, darin enthalten sein oder dieses als Bestandteil enthalten.

Der im Folgenden verwendete Ausdruck "poröse Struktur" kann der in dem erfindungsgemäßen Mikrosystem enthaltene Wärmeisolationskörper sein, darin enthalten sein oder diesen als Bestandteil enthalten.

In einer bevorzugten Ausführungsform ist ein erster Anteil der Partikel mittels einer Beschichtung zu einer porösen Struktur verbunden und ein zweiter Anteil der Partikel ist nicht mittels der Beschichtung verbunden.

Der erste Anteil von Partikeln ist näher an einer Öffnung der Aussparung angeordnet als der zweite Anteil von Partikeln, so dass ein Entweichen des zweiten Anteils von Partikeln aus der Aussparung durch die Öffnung verhindert wird. Dies ermöglicht, dass Eigenschaften des unbeschichteten Anteils von Partikeln von der Beschichtung wenig oder nicht beeinflusst werden. Gleichzeitig kann mittels der Anordnung von Partikeln eine hohe Oberfläche und mithin eine hohe Porosität erhalten werden.

Durch die Verbindung der Partikel sind diese verfestigt und bilden eine Verbundstruktur. In einer Ausführungsform sind die gesamten Partikel in die Verbundstruktur eingebunden. Die Herstellung der Verbundstruktur wird unten beschrieben.

Gemäß einem weiteren Ausführungsbeispiel umfasst der erste Anteil von Partikeln eine Vielzahl von zwischen den Partikeln des ersten Anteils angeordneten Hohlräumen, die zumindest teilweise miteinander verbunden sind, wobei die poröse Struktur unbeweglich mit dem Substrat verbunden ist. Vorteilhaft an diesem Ausführungsbeispiel ist unter anderem die Stabilisierung des Substrats.

Gemäß einem weiteren Ausführungsbeispiel grenzt die Öffnung der Aussparung an eine Kavität der Vorrichtung oder an die Umgebung an. Vorteilhaft daran ist, dass der zweite Anteil von Partikeln durch den ersten Anteil von Partikeln an Ort und Stelle gehalten werden kann. Bezogen auf die Kavität der Vorrichtung, beispielsweise ein inneres Volumen, kann so ein Herausfallen oder Rieseln des zweiten Anteils von Partikeln verhindert werden.

Gemäß einem weiteren Ausführungsbeispiel umfasst ein Verfahren zum Herstellen einer Vorrichtung ein Bereitstellen eines Substrats, das eine Aussparung aufweist, ein Einbringen einer Vielzahl von Partikeln in die Aussparung. Das Verfahren umfasst ferner ein Beschichten eines Anteils der Vielzahl von Partikeln, so dass der erste Anteil zu einer porösen Struktur verbunden ist.

Die Beschichtung erfolgt durch einen Beschichtungsprozess, der eine Eindringtiefe von einer Öffnung der Aussparung ausgehend in die Aussparung hinein aufweist. Die Eindringtiefe wird so eingestellt, dass ein zweiter Anteil der Partikel nicht mittels der Beschichtung verbunden ist, der erste Anteil von Partikeln zwischen dem zweiten Anteil von Partikeln und einer Umgebung der Aussparung angeordnet ist und eine Bewegung des zweiten Anteils von Partikeln hin zu der Umgebung der Aussparung im Wesentlichen verhindert ist. Das heißt, der erste Anteil von Partikeln kann der Öffnung der Aussparung zugewandt angeordnet sein.

Fig. 2b zeigt eine schematische Seitenschnittansicht einer Vorrichtung, die ein Substrat 1 aufweist. Das Substrat 1 umfasst eine Aussparung 20, beispielsweise ein Sackloch, einen Graben oder eine Vertiefung. In der Aussparung 20 ist eine Vielzahl von Partikeln angeordnet. Ein erster Anteil 17 der Partikel ist mittels einer Beschichtung zu einer porösen Struktur 5 verbunden. Ein zweiter Anteil 18 der Partikel ist nicht mittels der Beschichtung verbunden.

Der erste Anteil 17 der Partikel ist näher an einer Öffnung 19 der Aussparung 20 angeordnet als der zweite Anteil 18 der Partikel. Ein Entweichen des zweiten Anteils 18 von Partikeln aus der Aussparung durch die Öffnung 19 derselben ist mittels der porösen Struktur 5, d.h. des ersten Anteils 16 der Partikel verhindert. Die poröse Struktur 5 kann mit dem Substrat 1 fest verbunden sein, etwa indem der erste Anteil 17 und das Substrat 1 eine gleiche Beschichtung aufweisen und die Beschichtung sowohl die Partikel des ersten Anteils 16 untereinander als die poröse Struktur 5 mit dem Substrat 1 verbindet. Alternativ ist ebenfalls vorstellbar, dass die poröse Struktur 5 auf andere Art und Weise mit dem Substrat 1 verbunden wird, beispielsweise durch ein Druck-, Press- oder Klebeverfahren.

Die poröse Struktur 5 ist ausgebildet, so dass sie eine Vielzahl von Hohlräumen aufweist, die zumindest teilweise miteinander verbunden sind. Die Hohlräume können dadurch erhalten werden, dass miteinander in Kontakt gebrachte Partikel dazwischen angeordnete Hohlräume aufweisen, die durch die Beschichtung zumindest teilweise unverschlossen bleiben.

Eine Beschichtung des ersten Anteils 16 kann mittels eines beliebigen, dafür geeigneten Verfahrens (Beschichtungsprozesses) ausgeführt werden, beispielsweise eine Atomlagenabscheidung (Atomic Layer Deposition - ALD), einer physikalischen Gasphasenabscheidung (Physical Vapor Deposition - PVD) oder einer chemischen Gasphasenabscheidung (Chemical Vapor Deposition - CVD).

Beispielsweise kann im Zuge eines Herstellungsverfahrens eine Vielzahl von Partikeln in die Aussparung 20 angeordnet werden, wobei die Partikel verschiedenartig, aber auch gleichartig sein können. Nachfolgend kann eine Beschichtung des ersten Anteils 16 erfolgen, indem die Beschichtungsparameter entsprechend gewählt werden oder die Beschichtung beendet oder abgebrochen wird, wenn eine hinreichende Anzahl von Partikeln beschichtet ist, so dass der erste Anteil 17 die poröse Struktur 5 bilden kann. Der Beschichtungsprozess kann eine Eindringtiefe 21 aufweisen, die eine Wirksamkeit (Beschichten von Partikeln) des Beschichtungsprozesses von der Öffnung 19 ausgehend entlang einer Tiefenrichtung 22 in die Aussparung 20 hinein beschreibt. Vereinfacht ausgedrückt, sind Partikel des ersten Anteils 16 im Wesentlichen mit einem Abstand zu der Öffnung 19 angeordnet, der geringer oder gleich der Eindringtiefe 21 des Beschichtungsprozesses ist.

Die Partikel des zweiten Anteils 18 können mit einem Abstand zu der Öffnung 19 angeordnet sein, der größer als die Eindringtiefe 21 des Beschichtungsprozesses ist. Die Einstellung der Eindringtiefe 21 kann eine Einstellung eines Parameters des Beschichtungsprozesses, etwa Druck, Zeit, Temperatur oder dergleichen umfassen. Bspw. kann eine Einstellung der Eindringtiefe 21 so erfolgen, dass für eine Atomlagenabscheidung (Beschichtungsprozess) eine Verweildauer eines ersten oder zweiten Reaktanden so eingestellt wird, dass dieser die Partikel von der Öffnung 19 bzw. einer Deckfläche (Füllstand) der Partikel lediglich bis hin zu der Eindringtiefe 21 durchdringt. Eine Beschichtung erfolgt bspw., indem beide Reaktanden (sequentiell nacheinander) mit dem Partikel in Berührung kommen und sich bspw. an dem Partikel ablagern. Bspw. kann ein Reaktand eingebracht und nicht an Partikeln angeordnete Anteile wieder entfernt (abgesaugt) werden, bevor ein weiterer Reaktand eingebracht wird. Kommen beide Reaktanden miteinander an den Partikeln in Berührung, kann dort eine Beschichtung gebildet werden. Wird die Verweildauer so eingestellt, dass zumindest einer der Reaktanden die Eindringtiefe 21 nicht überschreitet, so kann eine Beschichtung von Partikeln, die einen größeren Abstand zu der Öffnung 19 aufweisen als die Eindringtiefe 21, reduziert oder vermieden werden. Alternativ kann bspw. eine Beschichtungsdauer einer CVD-Abscheidung so eingestellt werden, dass eine Beschichtung von Partikeln mit einem größeren Abstand zu der Öffnung 19 als die Eindringtiefe 21 im Wesentlichen oder Vollständig verhindert ist. Bspw. kann bei Verwendung von Al₂O₃ eine "Eindringtiefe", innerhalb derer die Partikel beschichtet werden, in weiten Grenzen einstellbar sein. Es können Aspektverhältnisse über 1000 erreicht werden.

Das bedeutet, dass eine chemische oder physikalische Eigenschaft des zweiten Anteils 18 der Vielzahl von Partikeln während eines Herstellungsverfahrens im Wesentlichen unverändert bleiben kann.

Das Beschichten kann von einer Seite der Umgebung der Aussparung 20 ausgehend in eine Richtung eines Volumens der Aussparung ausgeführt werden. Das ermöglicht, dass benachbart zu der Öffnung 19 der Aussparung angeordnete Partikel (der erste Anteil 17) beschichtet werden während von der Öffnung 19 beabstandete Partikel unbeschichtet bleiben.

Das Verhältnis der Anzahl von Partikeln des zweiten Anteils zu der Anzahl von Partikeln des ersten Anteils kann 0,01, 0,1, 0,2, 0,5, 1, 2, 10 oder größer sein. Das bedeutet, es können mehr unbeschichtete Partikel als beschichtete Partikel angeordnet sein, oder umgekehrt. In einer Ausführungsform sind alle Partikel beschichtet.

Bei dem Substrat 1 kann es sich bspw. um ein Hableitermaterial handeln. Bei dem Halbleitermaterial kann es sich bspw. um ein Siliziummaterial oder ein Galliumarsenidmaterial handeln. Alternativ oder zusätzlich kann das Substrat 1 ein Glasmaterial, ein Keramikmaterial, ein Glaskeramikmaterial und/oder ein Kunststoffmaterial umfassen. Das Substrat 1 kann eine Dotierung aufweisen. Bspw. kann das Halbleitermaterial dotiert sein, etwa mit einem Bormaterial. Beispielsweise handelt es sich bei dem Substrat 1 um einen MEMS-Wafer. Das Substrat 1 kann eine planare oder nichtplanare Form (bspw. gekrümmt) aufweisen.

Wird der Beschichtungsprozess (insbesondere die Verweilzeit der Reaktanten) modifiziert, so kann erreicht werden, dass die eingebrachten Partikel lediglich bis zu einer bestimmten Tiefe beschichtet werden.

Ein Herausfallen der nicht-beschichteten, d.h. losen Partikel kann verhindert werden, indem die poröse Struktur mit dem Substrat 22 verbunden wird oder ein Lösen der porösen Struktur 5 von dem Substrat verhindert wird. Dadurch kann erreicht werden, dass Materialien in Pulverform, d.h. der zweite Anteil der Partikel, in einen miniaturisierten Container, d. h., der Aussparung, eingeschlossen werden.

In einer Ausführungsform werden die eingebrachten Partikel in den entsprechenden Schritten jeweils nur oberflächlich beschichtet. Um eine Interaktion der reaktiven Partikel mit der Umgebung zu vermeiden, können dabei ALD-Prozesse verwendet werden, die auch bei niedrigen Temperaturen eine hohe Wirksamkeit aufweisen, wie es beispielsweise für Al₂O₃ der Fall ist.

Vorangehend beschriebene Ausführungsbeispiele sind von der Größe (beispielsweise Durchmesser oder laterale Abmessung) der Partikel unabhängig.

Obwohl vorangehend beschriebene Ausführungsbeispiele so beschrieben wurden, dass die poröse Struktur Hohlräume aufweist, die zumindest teilweise miteinander verbunden sind, so dass die poröse Struktur 5 eine poröse Membran bildet, kann, insbesondere bei einer Partikelgröße von < 2 µm, mittels der Beschichtung auch erreicht werden, dass die poröse Struktur 5 abgedichtet ist, d.h. die Hohlräume zwischen den Partikeln verschlossen sind. So kann mittels der Beschichtung eine Aussparung auch verschlossen werden.

### Ausführungsbeispiele

Unter Verwendung des in DE 10 2011 010 899 A1 beschriebenen Verfahrens wird eine membranbasierte Hotplate mit einem porösen, unter Vakuum versiegelten Support versehen. Da sich die Partikel eines solchen porösen Körpers nur punktuell berühren und ein Umgebungsmedium fehlt, ist die Hotplate nach unten weitaus besser isoliert als bei herkömmlichen Bauelementen ohne poröse Struktur (Wärmeisolationskörper).

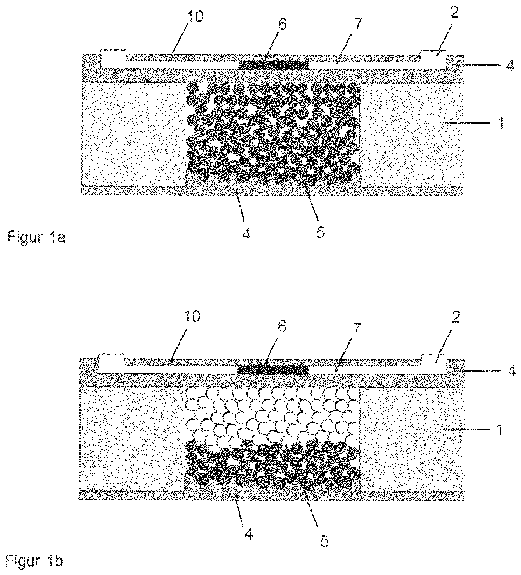

Eine erste Ausführungsform ist in Fig. 1 dargestellt. Die Kavitäten werden unterhalb der Membran auf Substratebene von der Rückseite her mit Partikeln aus einem thermisch schlecht leitenden Material verfüllt (z. B. SiO₂) und diese mit einer Al₂O₃-ALD-Schicht verfestigt. Danach werden die porösen Körper durch Aufbringen einer Versiegelungsschicht auf die Substratrückseite, z. B. mittels PECVD, unter Vakuum verschlossen. Das Entfernen eines Teils der Partikel oder des Substrats ist nicht zwingend notwendig.

Im Unterschied zu Fig. 1a illustriert Fig. 1b den Fall, dass die Partikel unterhalb der Membran nicht vollständig verfestigt werden.

Bei der Ausführung in Fig. 2a werden die thermisch isolierenden Bereiche vor den sensorspezifischen Strukturen erzeugt, d. h. in den Herstellungsprozess des Sensors integriert. Das Substrat mit den eingebetteten porösen Bereichen wird optional vor der weiteren Bearbeitung planarisiert, z.B. durch Schleifen und Polieren. Dabei wird zumindest ein Teil der verfestigten Partikel entfernt. Anschließend wird eine Abdeckschicht aufgebracht, die die porösen Bereiche versiegelt. Erst danach werden die sensorspezifischen Strukturen prozessiert. In Fig. 2b sind die Partikel (analog zu Fig. 1b) nicht vollständig verfestigt. Mehr noch, die unverfestigten Partikel können durch die poröse Struktur des verfestigten Bereiches vor dem Aufbringen der Versiegelungsschicht herausgeätzt werden.

Die thermische Isolation einer Hotplate mittels eines porösen Körpers gemäß Fig. 1 oder Fig. 2 bietet entscheidende Vorteile im Vergleich zu herkömmlichen MEMS-Bauelementen.

Vorteile dieser Ausgestaltung sind die mechanische Versteifung der Hotplate und die Unterdrückung von Konvektionseffekten und Druckschwankungen in der Kavität unterhalb der Sensormembran, die zu einer Verfälschung der Messung führen können.

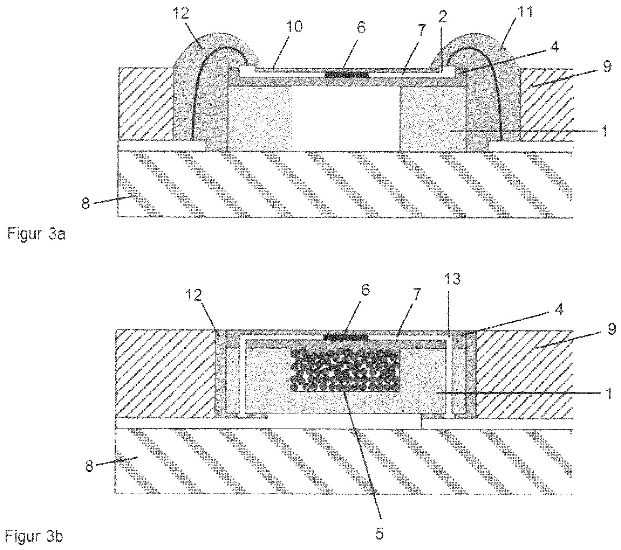

Ein weiterer Vorteil ist die Verarbeitbarkeit des Silizium-Substrats mit eingebetteten porösen Strukturen wie ein normaler Wafer. Mittels etablierter Techniken der Halbleitertechnologie können leicht vertikale elektrische Durchführungen (Through Silicon Vias, TSV) zur räumlichen Trennung der elektrischen Anschlüsse vom Sensorbereich integriert werden. Durch die Verlagerung der elektrischen Anschlüsse auf die Rückseite des Sensorchips wird dessen Aufbau- und Verbindungstechnik erheblich vereinfacht. Bei herkömmlichen Bauelementen müssen gemäß Fig. 3a die Bonddrähte mit einem geeigneten Kunststoff (Glob-Top) vergossen werden, wenn das zu überwachende Medium korrosiv ist oder Feuchtigkeit enthält. Oftmals wird noch eine Abdeckung montiert, um die elektrischen Zuleitungen auf dem Träger zu schützen. Im Falle eines Flussmessers wird durch die vergossenen Bonddrähte die Strömung des zu überwachenden Mediums beeinträchtigt. Bauelemente mit TSV erfordern allenfalls die Abdeckung und eine Abdichtung der Spalten, siehe Fig. 3b. Die Strömung des Mediums über die Sensoroberfläche wird nahezu nicht verfälscht.

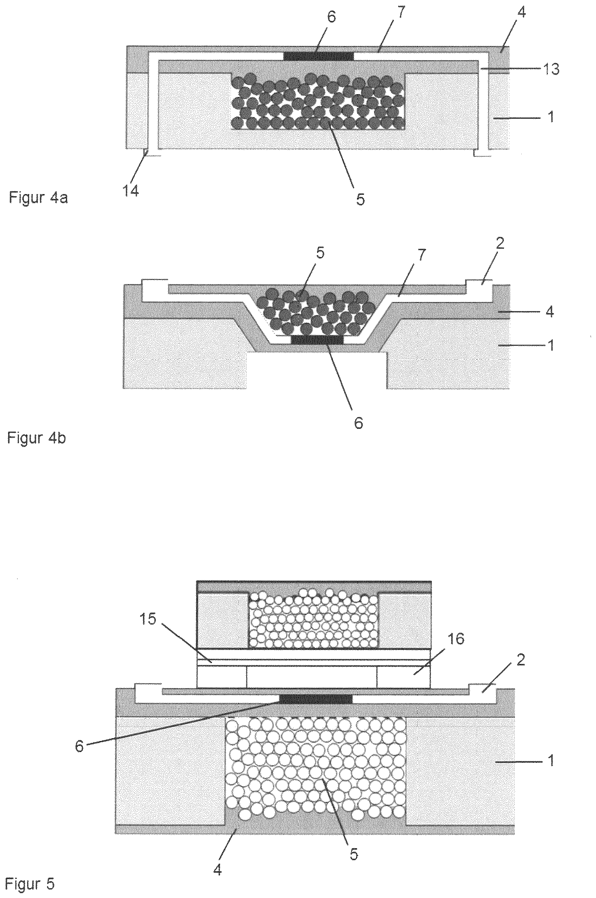

Fig. 4 zeigt zwei mögliche Ausführungen eines Bauelements mit einem thermisch isolierenden porösen Bereich unterhalb der Hotplate und einer räumlichen Trennung der elektrischen Anschlüsse vom Sensorbereich. Letzteres kann auch ohne TSV erreicht werden, siehe Fig. 4b.

Die Hotplate wird auf dem Boden einer KOH-geätzten Kavität mit schrägen Seitenflächen erzeugt. Die elektrischen Verbindungen zum Heizer werden über die schrägen Seitenflächen der Kavität auf die Oberfläche herausgeführt. Anschließend wird die Kavität mit Partikeln verfüllt. Nach Aufbringen einer Versiegelungsschicht kann die Oberfläche optional noch planarisiert werden. Zum Schluss wird das Silizium des Substrats von der Rückseite entfernt, um den Heizer/Temperatursensor freizustellen. Das kann durch ganzflächiges Abtragen (Schleifen und Polieren) und anschließendes Ätzen mit Maske erfolgen. Das Rückdünnen des Substrats durch Schleifen und Polieren von der Rückseite ist auch bei der Ausführung gemäß Fig. 4a möglich. Diese neuartigen Isolationselemente vereinen die Möglichkeiten herkömmlicher Superisolationen mit mikrotechnischen Herstellungsverfahren. Dabei sorgen die losen Partikel im Innern der Isolation für minimale Kontaktflächen zwischen den einzelnen Partikeln, wodurch wiederum deren Beitrag thermische Leitfähigkeit stark verringert wird. Da zudem ein Vakuum innerhalb der Isolation herrscht, existiert ebenfalls keine Konvektion und die Wärmeleitung über die Molekulare Bewegung von Gassen entfällt ebenso.

### Bezugszeichenliste

- 1: Substrat
- 2: Bondpad
- 3: ALD-Schicht (Hülle)
- 4: Versiegelungsschicht
- 5: Wärmeisolationskörper
- 6: Heizer
- 7: elektrische Zuleitung
- 8: Träger
- 9: Abdeckung
- 10: Membran
- 11: Bonddraht
- 12: Glob-Top
- 13: elektrische Durchführungen (Through Silicon Vias, TSV)
- 14: Pad
- 15: Gold-Reflektor
- 16: Montageflächen
- 17: erster Anteil der Partikel
- 18: zweiter Anteil der Partikel
- 19: Öffnung
- 20: Aussparung
- 21: Eindringtiefe
- 22: Tiefenrichtung

## Patentansprüche

1. Mikrosystem, umfassend ein Heizelement (6) und einen porösen Wärmeisolationskörper (5), der aus Partikeln einer Größe von 10 nm bis 100 µm und einer Wärmeleitfähigkeit von weniger als 10 W/(m·K) zusammengesetzt ist, wobei der Wärmeisolationskörper eine Porosität von 1 bis 70% aufweist und mit Unterdruck beaufschlagt ist.

2. Mikrosystem nach Anspruch 1, wobei die Partikel eine Wärmeleitfähigkeit von weniger als 3 W/(m·K) aufweisen.

3. Mikrosystem nach Anspruch 1 oder 2, wobei mindestens ein Anteil der Partikel mittels einer Beschichtung (3) miteinander verbunden ist.

4. Mikrosystem nach Anspruch 3, wobei alle Partikel mittels einer Beschichtung (3) miteinander verbunden sind.

5. Mikrosystem nach einem der vorstehenden Ansprüche, wobei der poröse Wärmeisolationskörper durch eine allseitige Umwandung abgeschlossen ist, so dass unbeschichtete Partikel unbeweglich eingeschlossen sind.

6. Mikrosystem nach Anspruch 5, wobei die allseitige Umwandung dadurch erhältlich ist, dass die Partikel durch eine Öffnung (19) in die Aussparung (20) eines Substrats (1) des Mikrosystems eingefüllt werden und diese Öffnung nach Aufbringen einer Beschichtung geschlossen wird, indem eine Versiegelungsschicht (4) aufgebracht wird und/oder indem mittels Beschichtung (3) der Partikel zumindest an der Öffnung ein fester Überzug gebildet wird.

7. Mikrosystem nach einem der vorstehenden Ansprüche, wobei der Wärmeisolationskörper (5) zwischen mindestens zwei Elementen, die beim Betrieb des Mikrosystems unterschiedliche Temperaturen aufweisen, und/oder zwischen dem Heizelement und der Umgebung angeordnet ist.

8. Mikrosystem nach einem der vorstehenden Ansprüche, wobei das Mikrosystem ein Durchflusssensor, ein Gassensor, ein Bolometer oder eine Infrarot-Lichtquelle ist.

## Claims

1. A microsystem comprising a heating element (6) and a porous thermal insulation body (5) composed of particles having a size of 10 nm to 100 µm and a thermal conductivity of less than 10 W/(m-K), said thermal insulation body having a porosity of 1 to 70% and being subjected to negative pressure.

2. The microsystem of claim 1, wherein the particles have a thermal conductivity of less than 3 W/(m-K).

3. The microsystem according to claim 1 or 2, wherein at least a portion of the particles is bonded together by means of a coating (3).

4. The microsystem according to claim 3, wherein all particles are bonded together by means of a coating (3).

5. The microsystem according to any one of the preceding claims, wherein the porous thermal insulation body is sealed by an all-round enclosure so that uncoated particles are immovably enclosed.

6. The microsystem according to claim 5, wherein the all-round conversion is obtainable by filling the particles through an opening (19) into the recess (20) of a substrate (1) of the microsystem and closing this opening after application of a coating by applying a sealing layer (4) and/or by forming a solid coating at least at the opening by means of coating (3) the particles.

7. The microsystem according to any one of the preceding claims, wherein the thermal insulation body (5) is arranged between at least two elements which have different temperatures during operation of the microsystem and/or between the heating element and the environment.

8. The microsystem according to any one of the preceding claims, wherein the microsystem is a flow sensor, a gas sensor, a bolometer or an infrared light source.

## Revendications

1. Microsystème, comprenant un élément chauffant (6) et un corps d'isolation thermique poreux (5) composé de particules d'une taille de 10 nm à 100 µm et d'une conductivité thermique inférieure à 10 W/(m·K), le corps d'isolation thermique poreux présentant une porosité de 1 à 70 % et étant sollicité par dépression.

2. Microsystème selon la revendication 1, dans lequel les particules présentent une conductivité thermique inférieure à 3 W/(m·K).

3. Microsystème selon la revendication 1 ou 2, dans lequel au moins une quote-part des particules sont reliées les unes aux autres au moyen d'un revêtement (3).

4. Microsystème selon la revendication 3, dans lequel toutes les particules sont reliées les unes aux autres au moyen d'un revêtement (3).

5. Microsystème selon une des revendications précédentes, dans lequel le corps d'isolation thermique poreux est isolé par un cloisonnement sur tous les côtés de telle sorte que des particules non-revêtues sont enfermées de manière immobile.

6. Microsystème selon la revendication 5, dans lequel le cloisonnement sur tous les côtés peut être obtenu de telle sorte que les particules sont chargées par une ouverture (19) dans l'évidement (20) d'un substrat (1) du microsystème et cette ouverture est fermée après application d'un revêtement en appliquant une couche de scellement (4) et/ou en formant un recouvrement fixe au moyen du revêtement (3) des particules au moins au niveau de l'ouverture.

7. Microsystème selon une des revendications précédentes, dans lequel le corps d'isolation thermique (5) est disposé entre au moins deux éléments qui présentent des températures différentes pendant le fonctionnement du microsystème et/ou entre l'élément chauffant et l'environnement.

8. Microsystème selon une des revendications précédentes, dans lequel le microsystème est un capteur de débit, un capteur de gaz, un bolomètre ou une source de lumière infrarouge.
